# EUROPEAN PATENT APPLICATION

(11) **EP 0 851 725 A1**
(43) Date of publication of application: **01.07.1998**
(21) Application number: 97310481.3
(22) Date of filing: 23.12.1997
(51) Int. Cl.: H05K 3/46

(54) **Multi-layer wiring board**

(30) Priority: 27.12.1996 JP 350811/96
(71) Applicant: SHINKO ELECTRIC INDUSTRIES CO. LTD., Nagano-shi, Nagano 380 (JP)
(72) Inventor: Horiuchi, Michio, Oaza Kurita, Nagano-shi, Nagano 380 (JP); Takeuchi, Yukiharu, Oaza Kurita, Nagano-shi, Nagano 380 (JP)
(74) Representative: Rackham, Stephen Neil

(57) **Abstract**

A multi-layer wiring board, the conductor pattern formation density of which can be further increased and the manufacturing process of which can be simplified comprises: a plurality of resin base plates (12, 12, ...) laminated on each other so that they are integrated into one body, a conductor pattern (10) being formed on one side of each resin layer (14); and conductive vias (18) to connect the conductor patterns (10, 10, ...) laminated on each other through the resin layers (14). The conductive vias (18) are formed when metal is filled by means of plating into recess portions (16) which penetrate the resin layers (14) so that the conductor pattern (10) formed on one side of each resin layer (14) is exposed onto a bottom surface of the recess portion and that the surfaces of the conductive vias can be substantially at the same level as the surface of the other side of each resin layer (14), whereby the exposed surfaces of the conductive vias (18) exposed on the other side of the resin layer (14) are electrically connected to the conductor pattern (10) formed on the one side of another resin base plate (12).

## Description

The present invention relates to a multi-layer wiring board having a conductive via. More particularly, the present invention relates to a multi-layer wiring board in which a plurality of resin base plates, on one surface of which a conductor pattern is formed, are laminated, subjected to heat treatment and integrated into one body.

In a multi-layer wiring board on which a plurality of conductor pattern layers are laminated through insulating layers interposed among them, it is necessary to form conductive vias by which the laminated conductor patterns are electrically connected with each other. Conventionally, the conductive vias are formed on the multi-layer wiring board in such a manner that through-holes are formed on the insulating layers with a tool such as a drill, and plating is conducted in the through-holes and a conductive adhesive agent is filled into the through-holes when necessary.

When the conventional conductive via is formed on a multi-layer wiring board as described above, since the diameter of the conductive via is determined by the size of a tool used for forming the conductive via such as a drill, the conductive via size is limited, that is, the conductive via formation density has a limit.

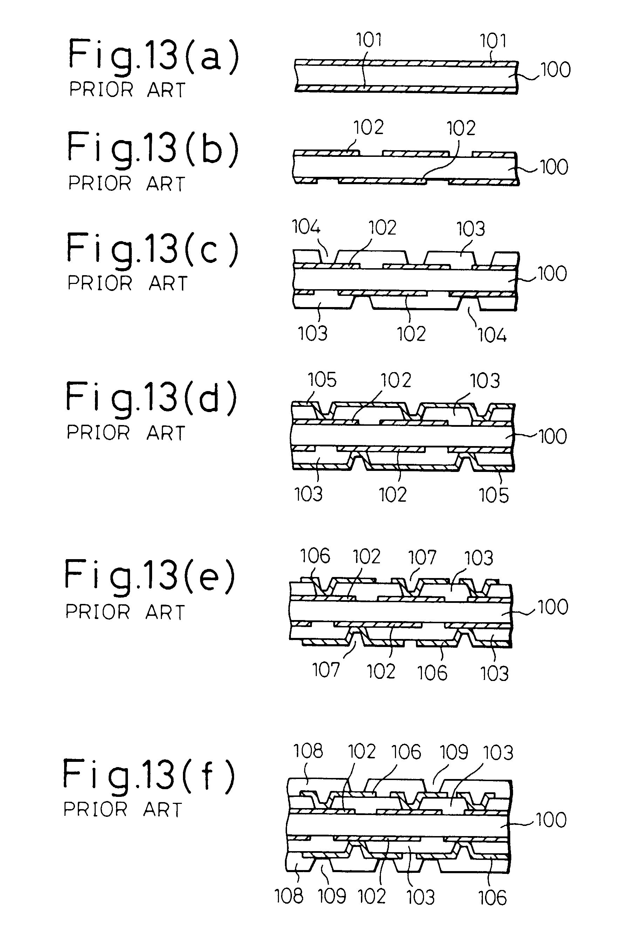

While the above conventional method of manufacturing a multi-layer wiring board is used on which the conductive vias are formed with a tool such a drill, there has also been proposed a buildup method as shown in Figs. 13(a) to 13(f).

According to this buildup method, pieces of copper foil 101, 101, which are metallic foils, are made to adhere onto both sides of a resin layer 100, and patterning is conducted on these pieces of copper foil 101, 101 by the method of photolithography, so that the desired conductor patterns 102, 102 can be formed in the process shown in Figs. 13(a) and 13(b).

Further, resin layers 104, 104, which are insulating layers, are formed on the thus formed conductor patters 102, 102 ··· , and then recess portions 104, 104 used for forming conductive vias are formed at predetermined positions by means of etching in the process shown in Fig. 13(c). The conductor pattern 102 is exposed on the bottom surface of the recess portion 104.

Next, after the copper layers 105, 105 have been formed on both sides (including the inner wall surfaces of the recess portions 104, 104 ···) of the resin layers 104, 104, on which the recess portions 104, 104 are formed, by means of electroless plating or sputtering, the desired conductor patterns 106, 106 are formed on the copper layers 105, 105 by the method of photolithography in the process shown in Figs. 13(d) and 13(e). The conductor pattern 106 is connected with the conductor pattern 102 by the conductive via 107 formed in such a manner that the copper layer 105 is provided on the inner wall of the recess portion 104.

Then, the resin layers 108, 108 are formed on the conductor patterns 106, 106 ··· . After that, recess portions 109, 109 for forming conductive vias are formed at predetermined positions by means of etching as shown in Fig. 13(f). Further, the process shown in Figs. 13(d) and 13(e) is repeated to form a multi-layer wiring board.

The conductor pattern formation density on the multi-layer wiring board obtained by the buildup method shown in Figs. 13(a) to 13(f) is higher than the conductor pattern formation density on the conventional multi-layer wiring board on which the conductive vias are formed with a tool such as a drill.

However, the manufacturing process of the buildup method is complicated, and the cost of the multi-layer wiring board obtained by the buildup method is higher than the cost of the conventional multi-layer wiring board.

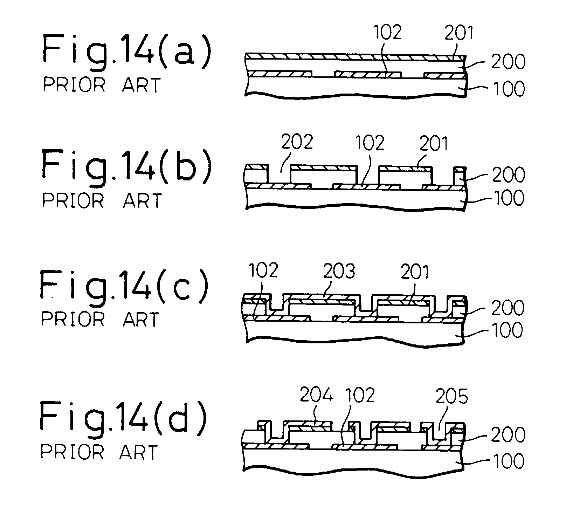

In order to simplify the process of manufacturing a multi-layer wiring board, there is used a film composed as shown in Fig. 14 in such a manner that a piece of copper foil is made to adhere onto one side of a resin base plate made of thermoplastic resin or intermediately hardened thermo-setting resin (resin layer at the B-stage), that is, a piece of copper foil is made to adhere onto one side of a resin base plate which exhibits an adhesive property when it is subjected to heat treatment.

In the same manner as that of the buildup method shown in Figs. 13(a) to 13(f), the process shown in Figs. 14(a) to 14(d) is executed in such a manner that after the desired conductor patterns 102, 102 ··· have been formed on the pieces of copper foil 101, 101 provided on both surfaces of the resin layer 100 by the method of photolithography, the films, on which the piece of copper foil 201 is joined onto one side of the resin layer 200 of B-stage, are made to adhere onto both surfaces of the resin layer 100 as shown in Fig. 14(a). When the films are joined onto both surfaces of the resin layer 100 as described above, heat treatment is conducted on the resin layer 200 while it is being pressed against the conductor pattern forming surface of the resin layer 100 so that the adhesive property of the resin layer 200 of B-stage can be exhibited.

In this connection, Figs. 14(a) to 14(d) are views showing a state in which the conductor pattern is laminated on one side of the resin layer 100.

On the resin layer 200 on which the conductor pattern 102 is laminated in the process shown in Fig. 14(a), there are formed recess portions 202 ··· used for the formation of conductive vias in such a manner that portions of copper foil at which the conductive vias are formed are removed by means of etching and then portions of resin exposed from the copper foil 201 are removed by irradiating laser beams as shown in Fig. 14(b).

After the copper layers 203 have been formed on the inner wall surfaces of the recess portions 202 and the overall surfaces of the copper foil 201 by means of electroless plating or spattering, the desired conductor patterns 204 ··· are formed on the copper foil 201, on which the copper layers 203 are laminated, by the method of photolithography in the process shown in Figs. 14(c) and 14(d). The conductor pattern 204 is connected with the conductor pattern 102 by the conductive via 205 in which the copper layer 203 is formed on the inner wall of the recess portion 202.

When the process shown in Figs. 14(a) to 14(d) is repeated after that, a multi-layer wiring board can be obtained.

According to the method shown in Figs. 14(a) to 14(d), it is possible to simplify the manufacturing method as compared with the buildup method shown in Figs. 13(a) to 13(f).

However, since the copper layer 203 is further formed on the copper foil 201 according to the above method, the thickness of the metallic layer, on which etching is conducted for the formation of the conductor pattern 204, is increased. For the above reasons, it has been found that the conductor pattern formation density of the conductor pattern on the multi-layer wiring board obtained by the method shown in Fig. 14 is lower than the conductor pattern formation density of the conductor pattern on the multi-layer wiring board obtained by the buildup method shown in Fig. 13.

Further, both methods shown in Figs. 13(a) to 13(f) and Figs. 14 (a) to 14(d) are disadvantageous in that it is impossible to form one conductive via immediately above another conductive via, so that the conductor pattern formation density cannot be increased.

Also, it has been found that when the recess portions used for the formation of conductive vias are filled with resin, the surface of the multi-layer wiring board becomes irregular because of the contraction of resin.

An object of the present invention is to provide a multi-layer wiring board, the conductor pattern formation density of which can be further increased, and the manufacturing process of which can be simplified. Also, a task to be accomplished by the present invention is to provide a multi-layer wiring board having a conductive via as described above.

The present inventors have made various investigations to solve the above problems and found the following. It is possible to simplify the process of manufacturing a multi-layer wiring board, by laminating resin base plates on which conductive vias are formed, when the recess portions, on the bottom surfaces of which the conductor patterns are exposed, are filled with metal by means of plating.

The present invention is to provide a multi-layer wiring board comprising: a plurality of resin base plates laminated on each other so that they are integrated into one body, a conductor pattern being formed on one side of each resin layer of the resin base plate which is an insulating layer; and conductive vias to connect the conductor patterns laminated on each other through the resin layers, the conductive vias being formed when metal is filled by means of plating into recess portions which penetrate the resin layers so that the conductor pattern formed on one side of each resin layer can be exposed onto the otherside and that the surfaces of the conductive vias can be at substantially the same level as the surface of the other side of each resin layer, whereby the exposed surfaces of the conductive vias exposed onto the other side of the resin layer are electrically connected to the conductor pattern formed on the other resin base plate.

In the present invention, the metal composing the conductive via may be a low melting point metal,the melting point of which is lower than the heat treatment temperature of laminating the plurality of resin base plates to integrate them into one body. Due to the foregoing, when the resin base plates are laminated on each other and subjected to heat treatment, the exposed surface of the conductive via can be easily connected with the conductor pattern.

Alternatively, the metal mainly composing the conductive via is a high melting point metal, the melting point of which is higher than the heat treatment temperature of laminating the plurality of resin base plates to integrate them into one body, and metal composing one end portion of the conductive via including the exposed surface of the conductive via is a low melting point metal, the melting point of which is lower than the heat treatment temperature. Due to the foregoing, when heat treatment is conducted, the exposed surface of the conductive via can be easily connected to the conductor pattern, and when heat treatment is conducted, all portions of the conductive via are not melted. Therefore, it is possible to enhance the dimensional and the positioning accuracy of the conductive via. Further, when copper is used as a high melting point metal, the electric resistance of the conductive via can be lowered compared with a case in which the conductive via is made of only solder.

When the metal mainly composing the conductive via is a high melting point metal, the melting point of which is higher than the heat treatment temperature of laminating the plurality of resin base plates to integrate them into one body, metal composing one end portion of the conductive via including the exposed surface of the conductive via is a low melting point metal, the melting point of which is lower than the heat treatment temperature, and metal composing the other end portion of the conductive via is a corrosion resistant metal with respect to an etching solution used in the case of formation of the conductor pattern. Due to the foregoing, the width of the conductor pattern with which the conductive via is connected can be made to be substantially the same as the width of the main body of the conductor pattern. Accordingly, the formation density of the conductor pattern can be further increased.

In the present invention, the resin base plate is a compound resin base plate, the resin layer, on one side of which the conductor pattern is formed, is a hard layer capable of maintaining a substantially hard state at the heat treatment temperature of laminating a plurality of resin base plates to integrate them into one body, and the resin layer joined onto the other side of the hard layer is an adhesive layer which exhibits an Adhesion property at the heat treatment temperature. When the above compound resin base plate is used, it is possible to enhance the dimensional accuracy and the positioning accuracy of the conductive via when the resin base plates are laminated on each other.

According to the present invention, the recess portion formed on the resin layer is filled with metal by means of plating so as to form a conductive via. Accordingly, unlike the conductive via composed in such a manner that a metallic layer is formed on the inner wall surface of the recess portion and resin is filled into a hollow portion in the recess portion, it is possible to easily obtain a multi-layer wiring board, the surface of which is flat.

Further, it is possible to form one conductive via immediately above another conductive via. Therefore, compared with the conventional multi-layer wiring board on which one conductive via cannot be formed immediately above another conductive via, the multi-layer wiring board of the invention is advantageous in that the degree of freedom of design of the conductor pattern can be enhanced and the formation density of the conductor pattern can be increased.

According to the present invention, it is possible to manufacture a multi-layer wiring board when the resin base plates, on which the conductor patterns and conductive vias are previously formed, are laminated and heat-treated. Therefore, compared with the conventional method of manufacturing a multi-layer wiring board, it is possible to simplify the manufacturing process by the method of the present invention.

Preferred embodiments in accordance with this invention will now be described with reference to the accompanying drawings, in which:
Fig. 1 is a partially cross-sectional view of an example of the multi-layer wiring board of the present invention;
Figs. 2 (a) to 2(d) are process drawings for explaining a portion of the method of manufacturing the multi-layer wiring board shown in Fig. 1;
Figs. 3 (a) and 3(b) are process drawings for explaining a portion of the method of manufacturing the multi-layer wiring board shown in Fig. 1;
Fig. 4 is a partially cross-sectional view of another example of the multi-layer wiring board of the present invention;
Figs. 5 (a) to 5(d) are process drawings for explaining a portion of the method of manufacturing the multi-layer wiring board shown in Fig. 4;
Figs. 6(a) and 6(b) are process drawings for explaining a portion of the method of manufacturing the multi-layer wiring board shown in Fig. 4;
Fig. 7 is a schematic illustration for explaining a state of connection between the conductor pattern and the conductive via when a wide connecting section is formed on the conductor pattern;
Fig. 8 is a schematic illustration for explaining a state of connection between the conductor pattern and the conductive via when a wide connecting section is not formed on the conductor pattern;
Fig. 9 is a partially cross-sectional view showing another example of the multi-layer wiring board of the present invention;
Figs. 10(a) to 10(d) are process drawings for explaining a portion of the method of manufacturing the multi-layer wiring board shown in Fig. 9;
Figs. 11(a) and 11(b) are process drawings for explaining a portion of the method of manufacturing the multi-layer wiring board shown in Fig. 9;
Fig. 12(a) to 12(c) are partial cross-sectional views of another example of the multi-layer wiring board of the present invention;
Figs. 13 (a) to 13(f) are process drawings for explaining a portion of the method of manufacturing the conventional multi-layer wiring board; and
Figs. 14 (a) to 14(d) are process drawings for explaining a method of manufacturing an improved multi-layer wirinq board.

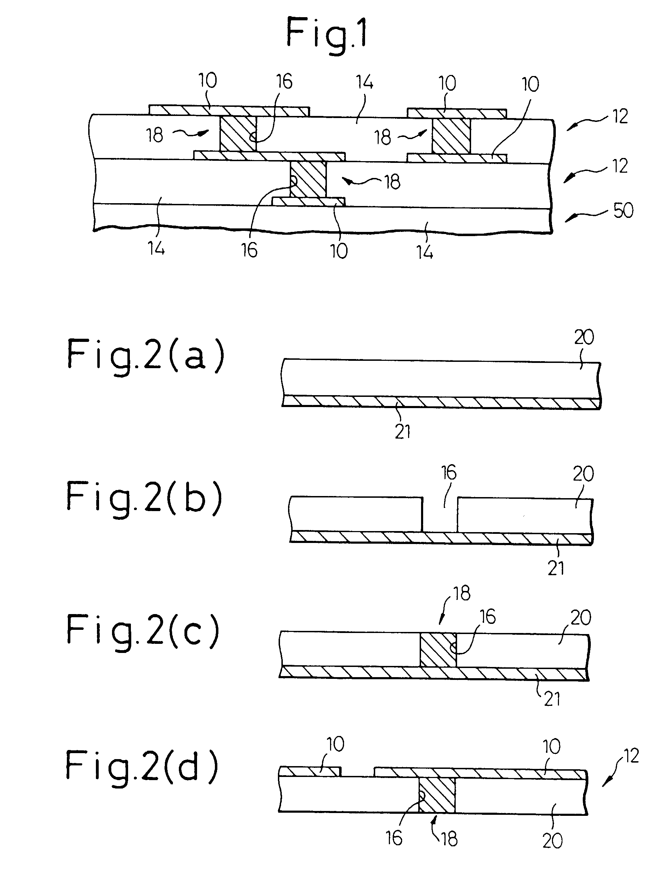

The present invention will be explained in detail referring to the accompanying drawings. Fig. 1 is a cross-sectional view for explaining an example of the multi-layer wiring board of the present invention. On the multi-layer wiring board shown in Fig. 1, a plurality of resin base plates 12, 12 ··· , on one side of which a conductor pattern 10 made of copper is formed, are laminated and integrated into one body with a resin base plate 50 on which a conductor pattern 10 is formed. On each of the plurality of resin base plates 12, there is formed a conductive via 18 which is composed in such a manner that a recess portion 16, which penetrates a resin layer 14 made of polyimide so that the conductor pattern 10 formed on one side can be exposed, is filled with solder by means of plating so that the surface of conductive via 18 can be the same as the surface of the other side of the resin layer 14. Concerning the thus formed conductive via, an exposed surface which is exposed onto the other side of the resin layer 14 is electrically connected with the conductor pattern 10 formed on another resin base plate 12. Therefore, the laminated conductor patterns 10, 10 ··· are electrically connected with each other on the multi-layer wiring board shown in Fig. 1.

The multi-layer wiring board shown in Fig. 1 is manufactured from a film shown in Fig. 2(a). This film includes: a resin layer (B stage resin layer) 20 made of thermosetting resin such as epoxy, polyimide or polyphenylene which is intermediately hardened; and a piece of copper foil 21 which is joined onto one side of the resin layer 20. A B stage resin layer 20 is an adhesive layer which exhibits an adhesive property when it is subjected to heat treatment and softened. It is possible to use a thermoplastic resin layer instead of the thermosetting resin layer (resin layer of stage B) 20. A thermoplastic resin layer, such as a polyimide, a polyphenylene, or the like, can be used.

First, a recess portion 16, on the bottom surface of which the copper foil 21 is exposed, is formed at a predetermined position on the film shown in Fig. 2(a) by means of laser beams in such a manner that the recess portion 16 penetrates the resin layer 20 of stage B (shown in Fig. 2(b)). Then, electrolytic plating is conducted when the copper foil 21 is used as an electrode. As a result of electrolytic plating, solder is filled into the recess portion 16 so that the surface of solder can be the same as the surface on the other side of the resin layer 20 (shown in Fig. 2(c)). In this way, the conductive via can be formed. Further, the conductor patterns 10, 10 ··· are formed when the metallic foil 21 is processed by the method of photolithography. In this way, the resin base plate 12 is formed (shown in Fig. 2(d)).

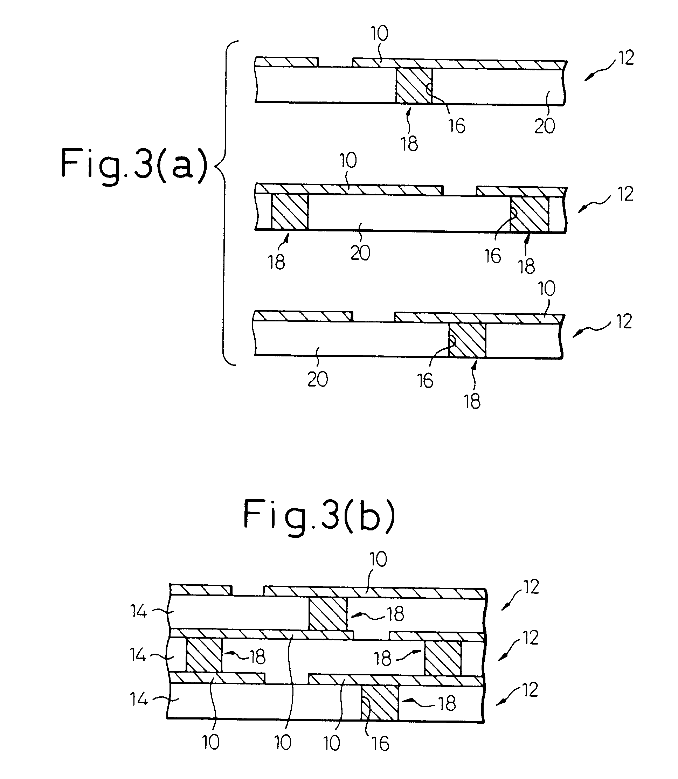

Next, as shown in Fig. 3(a), the resin base plates 12, 12 ··· are formed on which various conductor patterns are formed. After that, the resin base plates 12, 12 ··· are subjected to heat treatment while they are laminated on and pressed against each other. In this way, the adhesion property of the resin layers 20 of stage B is exhibited and the resin layers 12 are joined onto each other. In this case, a melting point of the solder composing the conductive via 18 is usually lower than the heat treatment temperature. Therefore, an exposed surface of the conductive via 18 coming into contact with the conductor pattern 10 composing another resin base plate 12 is melted and joined onto the conductor pattern 10. Accordingly, the conductive via 18 can be positively electrically connected with the conductor pattern 10.

As described above, according to the multi-layer wiring board shown in Figs. 1 to 3(b), when the resin base plates 12, 12 ··· , on which the desired patterns 10 are formed and the conductive vias 18 are formed at predetermined positions, are laminated on each other and heat-treated, the exposed surfaces of the conductive vias 18 can be easily connected with the conductor patterns 10 formed on other resin base plates 12. Due to the foregoing, it is possible to obtain a multi-layer wiring board, the upper surface of which is flat, and it is also possible to simplify the process of manufacturing the multi-layer wiring board.

In this case, when the above multi-layer wiring board shown in Figs. 1 to 3(b) is manufactured, the conductive vias 18 are composed of solder, the melting point of which is lower than the heat treatment temperature. However, material to compose the conductive vias 18 is not limited to the solder described above. Metal of a low melting point, which is lower than the heat treatment temperature, may be used instead of solder. Specifically, a single body of tin, lead, zinc, bismuth, antimony or indium, or alternatively alloy made of two types of metal, for example, alloy of tin silver, the melting point of which is not higher than 400°C, may be used for composing the conductive vias 18.

The conductor pattern 10 may be subjected to plating of nickel or gold to protect its surface and enhancing the wettability of the surface with respect to solder.

On the multi-layer wiring boards shown in Figs. 1 to 3(b), the entire conductive vias 18 are composed of a low melting point metal, the melting temperature of which is lower than the heat treatment temperature of solder. When the resin base plates 12, 12 ··· are laminated on each other and subjected to heat treatment so that they can be integrated into one body, the laminated resin base plates 12, 12 ··· are pressed against each other. Therefore, the low melting point metal composing the conductive vias 18 is melted and fluidized during the process of heat treatment, and further the resin layers 20 of stage B are temporarily softened and then hardened. For the above reasons, there is a possibility that the dimensional accuracy and the positioning accuracy of the conductive via 18 are deteriorated.

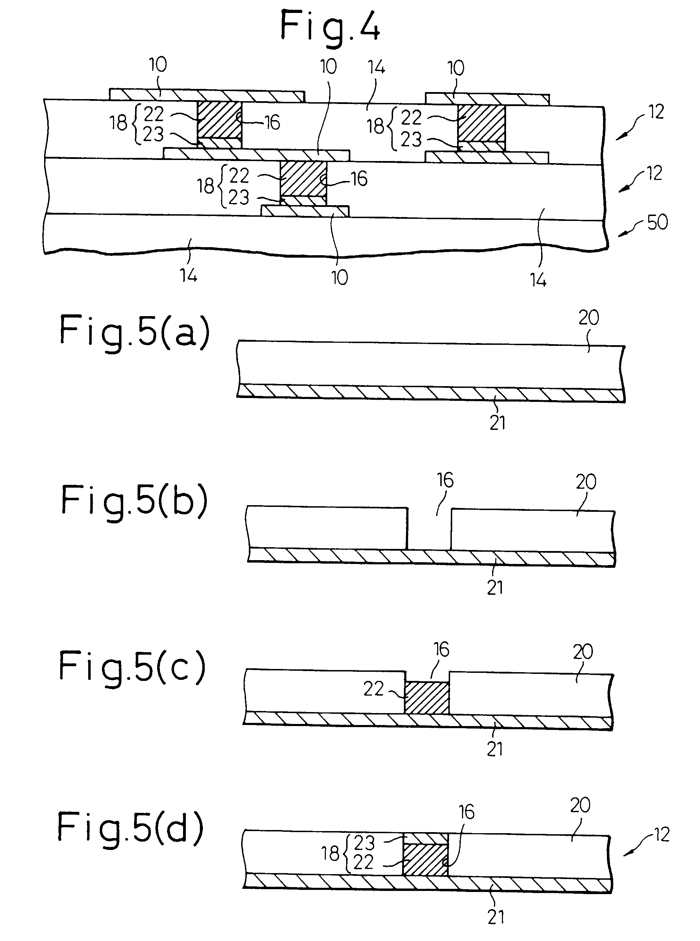

From the above viewpoint, it is possible to enhance the dimensional accuracy and the positioning accuracy of the conductive via 18 when the multi-layer wiring board shown in Fig. 4 is adopted.

On the multi-layer wiring board shown in Fig. 4, each conductive via 18 is also formed by means of plating, and the conductive via 18 is mainly composed of a copper section 22, and one end portion of the conductive via 18 including the exposed surface is a solder section 23.

In this connection, like reference characters are used to indicate like parts in Fig. 1 and 4, and detailed explanations are omitted here.

The multi-layer wiring board shown in Fig. 4 is manufactured as follows. In order to compose the multi-layer wiring board, there is used a film shown in Fig. 5(a), onto one surface of the resin layer (resin layer of B stage) 20 of which, a piece of copper foil 21 is joined, and this resin layer is made of thermosetting resin which is intermediately hardened. The recess portion 16, on the bottom surface of which the copper foil 21 is exposed, is formed at a predetermined position on this film by means of irradiating laser beams so that the recess portion 16 penetrates the resin layer 20 (shown in Fig. 5(b)).

Next, electrolytic plating is conducted when the copper foil 21 is used as an electrode, so that the recess portion 16 is filled with copper. In this way the copper section 22 is formed (shown in Fig. 5(c)). The recess portion 16 is mainly composed of the thus formed copper section 22. Further, a solder section 23 is laminated on the copper section 22 by means of electrolytic plating. In this way, the conductive via 18 is formed (shown in Fig. 5(d)).

Then, electrolytic plating is conducted when the copper foil 21 is used as an electrode. As a result of electrolytic plating, copper is filled into the recess portion 16 (shown in Fig. 5(c)). The recess portion 16 is mainly composed of the copper section 22. Further, the solder section 23 is laminated on the copper section 22 by means of electrolytic plating. In this way, the conductive via 18 is formed (shown in Fig. 5(d)).

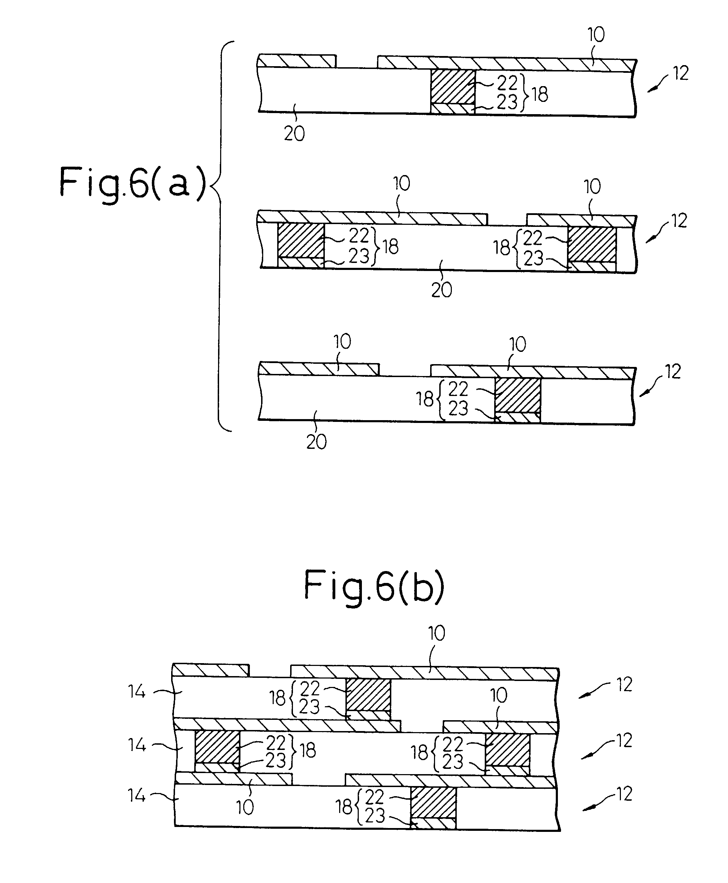

Next, the desired conductor patterns 10, 10 ··· are formed when the metallic foil 21 is processed by photolithography. In this way, the resin base plates 12, 12 ··· on which various conductor patterns 10, 10 ··· are formed can be provided as shown in Fig. 6(a).

Next, the resin base plates 12, 12 ··· are subjected to heat treatment while they are laminated on, and pressed against, each other as shown in Fig. 6(b). In this way, the adhesion property of the resin layers 20 of stage B is exhibited and the resin layers 12 are joined onto each other.

In this heat treatment, a solder section 23 composing the exposed surface of the conductive via 18 coming into contact with the conductor pattern 10 of another resin base plate 12 is melted and joined onto the conductor pattern 10. Accordingly, the conductive via 18 can be electrically connected with the conductor pattern 10.

Since the copper section 22 mainly composing the conductive via 18 is made of copper, which is a high melting point metal, the melting point of which is higher than the heat treatment temperature, even if the solder section 23 is fluidized and the resin layer 20 of stage B is softened in the process of heat treatment, the conductive via 18 can be held at a predetermined position by the copper section 22. Due to the foregoing, the dimensional accuracy and the positioning accuracy can be enhanced on the thus obtained multi-layer wiring board.

In this connection, even in the case of the multi-layer wiring boards shown in Figs. 3(a) to 6(b), when the resin base plates 12, 12 ··· , on which the desired conductor patterns 10 are formed and the conductive vias are formed at predetermined positions, are laminated on each other and subjected to heat treatment, the conductive vias 18 and the conductor patterns 10 can be easily connected with each other, and it is possible to manufacture a multi-layer wiring board, the surface of which is flat, and it is also possible to simplify its manufacturing process.

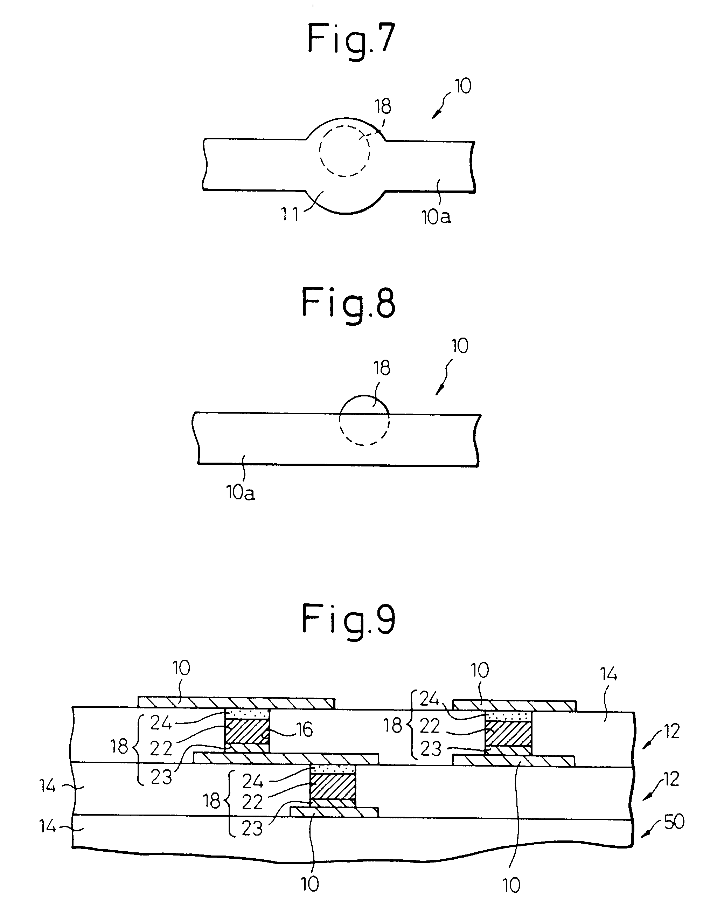

On the multi-layer wiring boards shown in Figs. 1 to 6(b), the connecting section 11 of the conductor pattern 10 to be connected with the conductive via 18 is wider than the main body 10a of the conductor pattern 10 as shown in Fig. 7. The reason why the connecting section 11 is wider than the main body 10a of the conductor pattern 10 is that the end surface of the conductive via 18 is not exposed even if the conductor pattern somewhat deconductive viates from the conductive via by the influence of dimensional inaccuracy of the conductive via 18 and the main body 10a of the conductor pattern.

However, when the wide connecting section 11 is formed on the conductor pattern 10 as shown in Fig. 7, it becomes necessary to maintain a longer interval between the patterns than the interval in the case in which the connecting section 11 is not formed on the conductor pattern 10. Therefore, it becomes difficult to form the conductor pattern 10 at a high formation density.

On the other hand, when no connecting section 11 is formed in the main body 10a of the conductor pattern, it becomes possible to form the conductor pattern at a high formation density. In some cases, the conductor pattern somewhat deviates from the conductive via under the influence of dimensional inaccuracy of the conductive via 18 and the main body 10a of the conductor pattern. Therefore, the end surface of the conductive via 18 deviates from the main body 10a of the conductor pattern as shown in Fig. 8. In the state shown in Fig. 8, there is a possibility that the conductive via 18 is etched by the etching solution.

The above problem can be solved by the multi-layer wiring board shown in Fig. 9. The conductive via 18 is mainly composed of a copper section 22 on the multi-layer wiring board shown in Fig. 9, and one end section of the conductive via 18 including the exposed surface is composed of a solder section 23, and the other end section of the conductive via 18 is composed of a tin section 24. In this connection, a nickel can also be used instead of tin.

The tin section 24 composing the other end section of the conductive via 18 is resistant to corrosion of the etching solution used when the conductor pattern 10 is formed on the copper foil 21 by means of etching. Accordingly, even if a portion of the end surface of the conductive via 18 is exposed from the main body 10a of the conductor pattern as shown in Fig. 8, it is possible to prevent the copper section 22 of the conductive via 18 from being etched by the etching solution.

In this connection, like reference characters are used to indicate like parts in Fig. 1 and 9, and detailed explanations are omitted here.

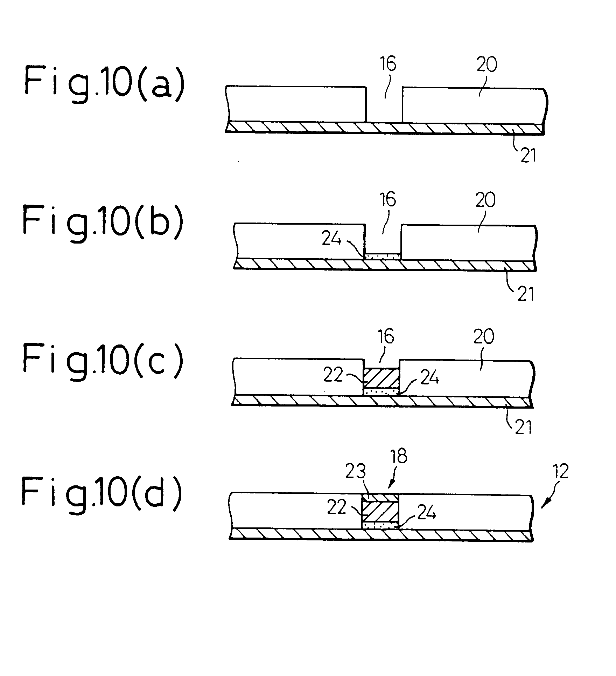

The multi-layer wiring board shown in Fig. 9 is manufactured as follows. In order to compose the multi-layer wiring board, there is used a film shown in Fig. 5(a), on one surface of the resin layer (resin layer of B stage) 20 of which a piece of copper foil 21 is joined, and this resin layer is made of thermosetting resin which is intermediately hardened. The recess portion 16, on the bottom surface of which the copper foil 21 is exposed, is formed at a predetermined position on this film by means of irradiating laser beams so that the recess portion 16 penetrates the resin layer 20 (shown in Fig. 10(a)).

Next, electrolytic plating is conducted while the copper foil 21 is used as an electrode, so that the bottom section of the recess 16 is filled with tin (Sn). In this way, the tin section 24 is formed (shown in Fig. 10(b)). The recess portion 16 is mainly composed of the thus formed copper section 22 which is made when the upper surface of the tin section 24 is filled with copper by means of electrolytic plating (shown in Fig. 10(c)). Further, the upper surface of the copper section 22 is filled with solder by means of electrolytic plating, so that the thus formed solder section 23 is laminated (shown in Fig. 10(d)). In this way, the conductive via 18 is formed.

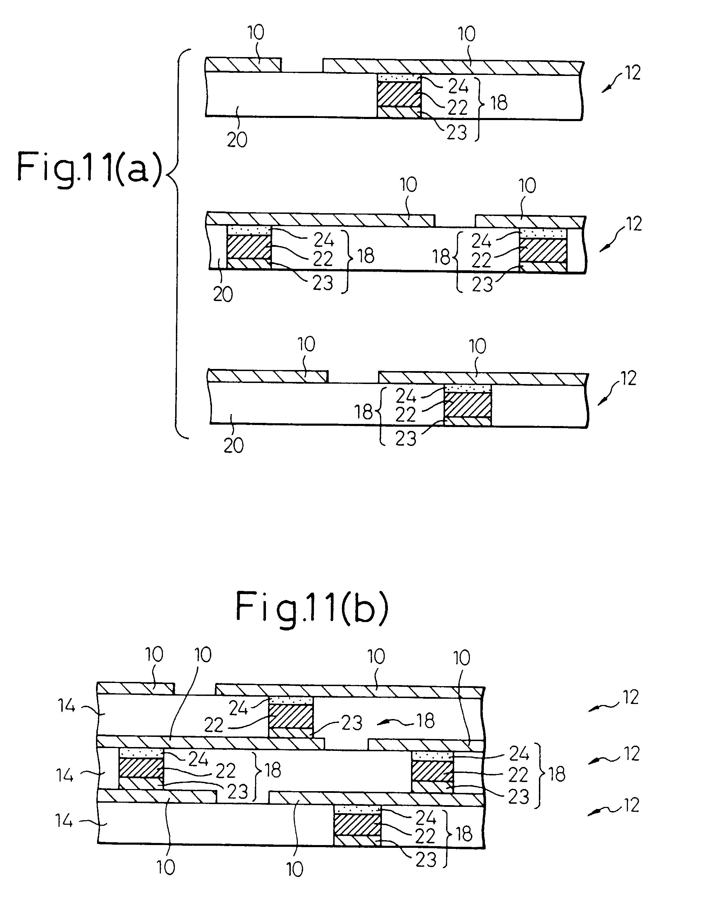

Then, the desired patterns 10, 10 ··· are formed on the metallic foil 21 by the method of photolithography. In this way, the resin base plates 12, 12 ··· on which various conductor patterns 10, 10 ·· are formed can be provided as shown in Fig. 11(a). Further, after the resin base plates 12, 12 ··· have been laminated on each other as shown in Fig. 11(b), they are subjected to heat treatment while they are being pressed against each other, so that the adhesion property of the resin layer 20 of stage B can be exhibited and the resin base plates 12 are made to adhere to each other.

On the multi-layer wiring boards shown in Figs. 9 to 11(b), the solder section 23 composing the exposed surface of the conductive via 18 which comes into contact with the conductor pattern 10 of the other resin base plate 12 is melted and joined onto the conductor pattern 10 in the process of heat treatment in the same manner as that of multi-layer wiring board shown in Figs. 4 to 6(b). Accordingly, the conductive via 18 can be positively joined onto the conductor pattern 10.

Since the copper section 22 mainly composing the conductive via 18 is made of copper, which is a high melting point metal, the melting point of which is higher than the heat treatment temperature, even if the solder section 23 is melted and the resin layer 20 of stage B is softened in the process of heat treatment, the conductive via 18 can be held at a predetermined position by the copper section 22. Due to the foregoing, the dimensional accuracy and the positioning accuracy can be enhanced on the thus obtained multi-layer wiring board.

In this connection, even in the case of the multi-layer wiring boards shown in Figs. 9 to 11(b), when the resin base plates 12, 12 ··· , on which the desired conductor patterns 10 are formed and the conductive vias are formed at predetermined positions, are laminated on each other and subjected to heat treatment, the conductive vias 18 and the conductor patterns 10 can be easily connected with each other, and it is possible to manufacture a multi-layer wiring board, the surface of which is flat, and it is also possible to simplify its manufacturing process.

On the multi-layer wiring boards shown in Figs. 1 to 11(b), the resin base plate 12 is made of a film composed in such a manner that a piece of copper foil 21 is joined onto one side of the resin layer 20. In this case, the film may be a compound film on which a resin layer 30a (referred to as a resin layer of stage C hereinafter), the thermosetting resin on the resin layer 20 of which is perfectly hardened, and a resin layer 30b of stage B are compounded with each other. This resin layer 30a of stage C is a hard layer which is not softened at the heat treatment temperature when the laminated resin base plates 12, 12 ··· are integrated with each other in the process of heat treatment.

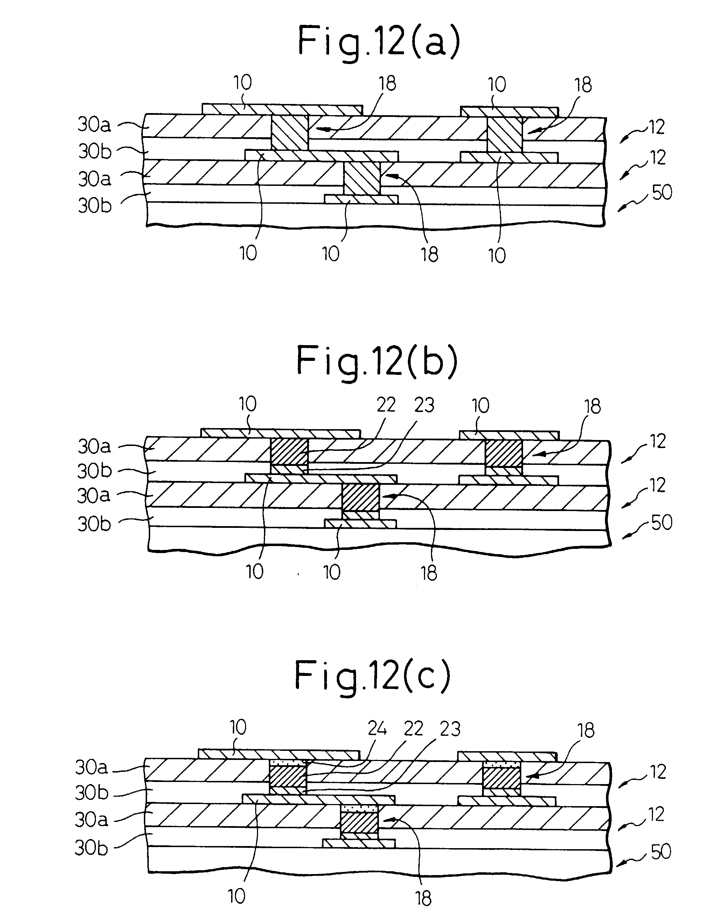

Figs. 12 (a) to 12(c) are views respectively showing a multi-layer wiring board on which the above compound film is used. Fig. 12(a) corresponds to the multi-layer wiring board shown in Fig. 1, on which the conductive via 18 is composed of solder.

Fig. 12(b) corresponds to the multi-layer wiring board shown in Fig. 4, on which the conductive via 18 is mainly composed of a copper section 22, and one end portion including the exposed surface of the conductive via 18 is a solder section 23.

Fig. 12(c) corresponds to the multi-layer wiring board shown in Fig. 9, on which the conductive via 18 is mainly composed of a copper section 22, and one end section including the exposed surface of the conductive via 18 is a solder section 23, and the other end section of the conductive via 18 is a tin section 24.

In this connection, instead of the resin layer 30b of stage B, it is possible to use a resin layer made of thermoplastic resin such as polyimide or polyphenylene which is softened and exhibits the adhesive property at the heat treatment temperature.

In this connection, the thermoplastic resin is superior to the thermosetting resin of stage B.

On the multi-layer wiring boards shown in Figs. 12(a) to 12(c), when the resin base plates 12, 12 ··· are laminated and integrated into one body in the process of heat treatment, the resin layer 30a of stage C can be maintained in a substantially hard condition even if the resin layer 30b is softened. Therefore, it is possible to enhance the dimensional accuracy and the positioning accuracy of the conductive via 18.

In this connection, the resin layers shown in Figs. 1 to 12 may contain inorganic powder of alumina, silica, mullite, aluminum nitride or calcium carbonate, the content of which is not less than 60 weight %.

### EXAMPLE 1

A multi-layer wiring board was made of a film shown in Fig. 2(a). The film shown in Fig. 2(a) was made in such a manner that thermosetting resin of epoxy was coated on a piece of copper foil 21, the thickness of which was 12 µm, and hardened intermediately, so that a resin layer 20 of stage B, the thickness of which was 60 µm, was formed.

First, recess portions 16, the diameter of which was approximately 50 µm, were formed on the resin layer 20 of this film by means of irradiating ultraviolet laser beams at predetermined intervals as shown in Fig. 2(b). The copper foil 21 was exposed on the bottom surface of the thus formed recess portion 16.

Then, electrolytic plating was conducted while the copper foil 21 was used as an electrode, so that the recess portions 16 was filled with eutectic solder of tin and lead to the surface of the resin layer 20. In this way, the conductive via 18 was formed as shown in Fig. 2(c).

Further, etching was conducted on the copper foil 21 with an etching solution, the principal components of which were ammonium ions, chloric ions and a copper complex. Due to the foregoing, predetermined conductor patterns 10, 10 ··· were formed by the copper foil 21. In this way, the resin base plate 12 was obtained as shown in Fig. 2(d).

After that, a plurality of resin base plates 12, 12 ··· , on which the conductive vias were formed at predetermined positions and the desired conductor patterns 10, 10 ··· were formed, were laminated on each other as shown in Figs. 3(a) and 3(b), and then the laminated body was subjected to preflux treatment at the temperature of about 150°C. Then, while it was pressed by a vacuum press at the pressure of 7 kgf/cm², heat treatment was conducted at 180°C for 30 minutes.

It was possible to integrate the laminated resin base plates 12, 12, 12 ··· into one body by the heat treatment described above, and a multi-layer wiring board, the surface of which was flat, was obtained.

In this case, the connecting condition of the conductor patterns 10 with the conductive vias 18 was inspected for each resin base plate 12, and only the resin base plates 12 which had passed the inspection were laminated.

### EXAMPLE 2

A film was used in this example which was composed as follows. In Example 1, a resin layer 30a of stage C made of thermosetting polyimide, which had been thermally hardened, the thickness of which was 25 µm, was formed on a piece of copper foil 21, the thickness of which was 9 µm. A resin layer 30b made of thermoplastic polyimide, the thickness of which was 40 µm, was formed on the above resin layer 30a. The condition of heat treatment in which a plurality of resin base plates 12, 12 ··· were laminated on each other was set in such a manner that the laminated body was subjected to heat treatment at 360°C for 5 minutes while the laminations were pressed against each other at a pressure of 20 kgf/cm². Other conditions were the same as those of Example 1. In this way, the multi-layer wiring board was provided.

When thermoplastic polyimide composing the resin layer 30b was softened in the above heat treatment condition, it exhibited an adhesive property, however, thermosetting polyimide composing the resin layer 30a, which had been thermally hardened, was not softened.

The surface of the thus obtained multi-layer wiring board was flat, and the dimensional accuracy and the positioning accuracy of the conductive via were excellent.

## Claims

1. A multi-layer wiring board comprising:
a plurality of resin base plates laminated on each other so that they are integrated into one body, a conductor pattern being formed on one side of each resin layer of the resin base plate which is an insulating layer; and
conductive vias for connecting the conductor patterns laminated on each other through the resin layers, the conductive vias being formed when metal is filled by means of plating into recess portions which penetrate the resin layers so that the conductor pattern formed on one side of each resin layer can be exposed onto the otherside and that the surfaces of the conductive vias can be at substantially the same level as the surface of the other side of each resin layer, whereby the exposed surfaces of the conductive vias exposed onto the other side of the resin layer are electrically connected to the conductor pattern formed on the other resin base plate.

2. A multi-layer wiring board according to claim 1, wherein metal composing the conductive via is a low melting point metal, the melting point of which is lower than the heat treatment temperature of laminating the plurality of resin base plates to integrate them into one body.

3. A multi-layer wiring board according to claim 1, wherein metal mainly composing the conductive via is a high melting point metal, the melting point of which is higher than the heat treatment temperature of laminating the plurality of resin base plates to integrate them into one body, and metal composing one end portion of the conductive via including the exposed surface of the conductive via is a low melting point metal, the melting point of which is lower than the heat treatment temperature.

4. A multi-layer wiring board according to claim 1, wherein metal mainly composing the conductive via is a high melting point metal, the melting point of which is higher than the heat treatment temperature of laminating the plurality of resin base plates to integrate them into one body, metal composing one end portion of the conductive via including the exposed surface of the conductive via is a low melting point metal, the melting point of which is lower than the heat treatment temperature, and metal composing the other end portion of the conductive via is a corrosion resistant metal with respect to an etching solution used in the case of formation of the conductor pattern.

5. A multi-layer wiring board according to any claim, wherein the resin base plate is a compound resin base plate, the resin layer, on one side of which the conductor pattern is formed, is a hard layer capable of maintaining a substantially hard state at the heat treatment temperature of laminating a plurality of resin base plates to integrate them into one body, and the resin layer joined onto the other side of the hard layer is an adhesive layer which exhibits an adhesion property at the heat treatment temperature.
